# DEMANDE DE BREVET EUROPEEN

(11) **EP 2 584 606 A2**
(43) Date de publication de la demande: **24.04.2013**
(21) Numéro de dépôt: 12354047.8
(22) Date de dépôt: 23.10.2012
(51) Int. Cl.: H01L 27/108, H01L 27/12, H01L 29/78

(54) **Cellule mémoire dynamique munie d'un transistor à effet de champ à pente sous le seuil verticale**

(30) Priorité: 21.10.2011 FR 1103232
(71) Demandeur: Commissariat à l'Énergie Atomique et aux Énergies Alternatives, 75015 Paris (FR); Centre National de la Recherche Scientifique, 75764 Paris Cedex 16 (FR)
(72) Inventeur: Wan, Jing, 38000 Grenoble (FR); Cristoloveanu, Sorin, 38170 Seyssinet Pariset (FR); Le Royer, Cyrille, 38210 Tullins-Fures (FR); Zaslavsky, Alexander, 02906 Providence Rhode Island (US)
(74) Mandataire: Talbot, Alexandre

(57) **Abrégé**

Une cellule mémoire est munie d'un transistor qui comporte des électrodes source et de drain (2, 3) formées dans un film semi-conducteur (4) par des zones dopées respectivement N et P. Le transistor comporte des premier et deuxième dispositifs de génération de barrière de potentiel dans le film semi-conducteur (4). Les deux barrières de potentiel sont décalées latéralement et s'opposent au passage des porteurs de charge émis l'électrode de source/drain la plus proche. Un des dispositifs (9) de génération de barrière de potentiel est relié électriquement à la grille (1). L'autre des dispositifs (15) de génération de barrière de potentiel est relié électriquement à une contre-électrode (14). L'écriture d'un état haut est réalisé en imposant sur l'électrode de type P un potentiel supérieur à celui de l'électrode de type N et charger le condensateur former entre la grille (1) et le film semi-conducteur (4). La réinitialisation de la cellule mémoire est obtenu en vidant le condensateur.

## Description

### Domaine technique de l'invention

L'invention est relative à une cellule mémoire dynamique comportant un transistor à effet de champ.

### État de la technique

Au fur et à mesure des évolutions technologiques, la densité d'intégration dans les circuits intégrés a augmenté de manière continue ce qui a permis d'incorporer un nombre toujours plus important de fonctions électronique pour une surface donnée de silicium.

Avec l'augmentation croissante des fonctionnalités des circuits intégrés, une quantité toujours plus importante de cellules mémoires est embarquée dans les puces électroniques. Afin d'accroitre encore la densité d'intégration dans les circuits intégrés, les architectures des cellules mémoires sont modifiées à chaque noeud technologique pour diminuer la surface occupée.

Les cellules mémoires dynamiques les plus denses sont de type 1T-DRAM. Ces cellules mémoires sont réalisées par un transistor qui est en mesure de conserver en son sein des charges électriques. Ces charges électriques ont un effet sur les caractéristiques électriques du transistor ce qui permet de définir un état haut et un état bas. De manière classique, cette catégorie de cellule mémoire sans capacité est obtenue par l'intermédiaire de transistors NMOS de type silicium sur isolant. Pour ce genre de cellule mémoire, les porteurs de charge majoritaires (des trous dans le cas de transistors NMOS) sont injectés dans la zone neutre du substrat flottant. Ces porteurs de charges, confinés dans une région bordée par l'oxyde enterré, l'oxyde de grille et les jonctions de source et de drain, s'accumulent dans le substrat flottant et modifient son potentiel. Dans le cas d'un transistor NMOS, cette augmentation de potentiel est reliée au courant de la jonction entre la source et le substrat flottant. Ainsi, l'introduction des charges dans le substrat flottant permet de réduire la tension de seuil du transistor. Le courant de drain est augmenté. Dans ce cas, le substrat flottant est utilisé en tant que zone de rétention d'une charge mémoire. Cette charge mémorisée (état 1 de la mémoire) peut être évacuée en polarisant en direct la jonction drain/substrat. L'état 0 de la mémoire correspond à une absence de charge dans le substrat flottant.

Dans ces cellules mémoires de type 1 T-DRAM, la création de charge est réalisée par l'ionisation par impact ou par « band to band tunneling » ce qui permet l'accumulation d'une grande quantité de trous. D'une manière générale, les porteurs de charges sont injectés dans ces cellules mémoires au moyen d'un champ électrique élevé qui est préjudiciable à la fiabilité des dispositifs. Un tel fonctionnement est utilisé couramment dans les cellules mémoires de type TCCT (Thin Capacitively-Coupled Thyristor). Une telle cellule comporte deux jonctions PN montées en série.

Il est alors un besoin de trouver des solutions qui permettent de former des cellules mémoires avec une forte densité d'intégration et une bonne tenue dans le temps.

### Objet de l'invention

On constate qu'il existe un besoin de proposer une cellule mémoire comportant un transistor à effet de champ dont la fiabilité est améliorée. Pour cela, on cherche une cellule mémoire selon les revendications annexées et plus particulièrement une cellule mémoire comportant :
- un transistor à effet de champ comportant :
   ○ une première électrode de source/drain formée dans un film en matériau semi-conducteur par une première zone dopée de type N,
   ○ une deuxième électrode de source/drain formée dans le film en matériau semi-conducteur par une deuxième zone dopée de type P,
   ○ une zone inter-électrode formée dans le film en matériau semi-conducteur et séparant les deux électrodes de source/drain,
   ○ une électrode de grille recouvrant au moins partiellement la zone inter-électrode,
   ○ une contre-électrode séparée de l'électrode de grille par le film en matériau semi-conducteur,
- un premier dispositif de génération d'une première barrière de potentiel dans le film semi-conducteur, la première barrière de potentiel s'opposant au passage de porteurs de charge émis par la première électrode de source/drain,
- un deuxième dispositif de génération d'une deuxième barrière de potentiel dans le film semi-conducteur, la deuxième barrière de potentiel s'opposant au passage de porteurs de charge émis par la deuxième électrode de source/drain, la deuxième barrière de potentiel étant décalée de la première barrière de potentiel selon un axe reliant les deux électrodes de source/drain, l'un des dispositifs de génération de barrière de potentiel étant configuré pour générer une barrière de potentiel à amplitude modulable et étant relié électriquement à l'électrode de grille, l'autre des dispositifs de génération de barrière de potentiel étant relié électriquement à la contre-électrode,
- un circuit d'application d'une première différence de potentiel entre la première électrode de source/drain et la deuxième électrode de source/drain configuré pour polariser l'électrode dopée de type P à un potentiel supérieur à celui de l'électrode dopée de type N,
- un circuit de commande configuré pour :
   ○ basculer le transistor à l'état passant puis à l'état bloquant pour écrire un état dans la cellule mémoire en chargeant le condensateur formé par l'électrode de grille et le film semi-conducteur,
   ○ décharger le condensateur pour réinitialiser la cellule mémoire et, appliquer un potentiel plus important sur l'électrode dopée de type P que sur l'électrode dopée de type N durant la phase de lecture de l'information stockée dans la cellule mémoire de manière à rendre le transistor passant lorsque le condensateur est chargé.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 à 6 représentent, de manière schématique, en vue de coupe transversale, différents modes de réalisation d'un transistor à pente sous le seuil verticale,
- les figures 7 et 8 représentent, de manière schématique, les diagrammes de bande d'un transistor soumis à différentes polarisations et, le courant circulant dans le transistor en fonction de la polarisation de l'électrode de grille,
- les figures 9a et 9b représentent, de manière schématique, les chronogrammes du potentiel appliqué sur l'électrode de drain du transistor et sur l'électrode de grille du transistor,
- les figures 10a et 10b représentent, de manière schématique, un transistor selon les figures 1 à 6 lors de la phase d'initialisation de la cellule mémoire et/ou d'écriture d'un premier état,
- les figures 11 a et 11 b représentent, de manière schématique, un transistor selon les figures 1 à 6 lors de la phase d'écriture d'un deuxième état dans la cellule mémoire.

### Description d'un mode préférentiel de l'invention

La cellule mémoire comporte un transistor connecté à un circuit de commande. Le transistor est de type Z²FET, c'est-à-dire un transistor à effet de champ sans ionisation par impact et avec une pente sous le seuil verticale (pour Zero swing and Zero ionisation Field Effect Transistor).

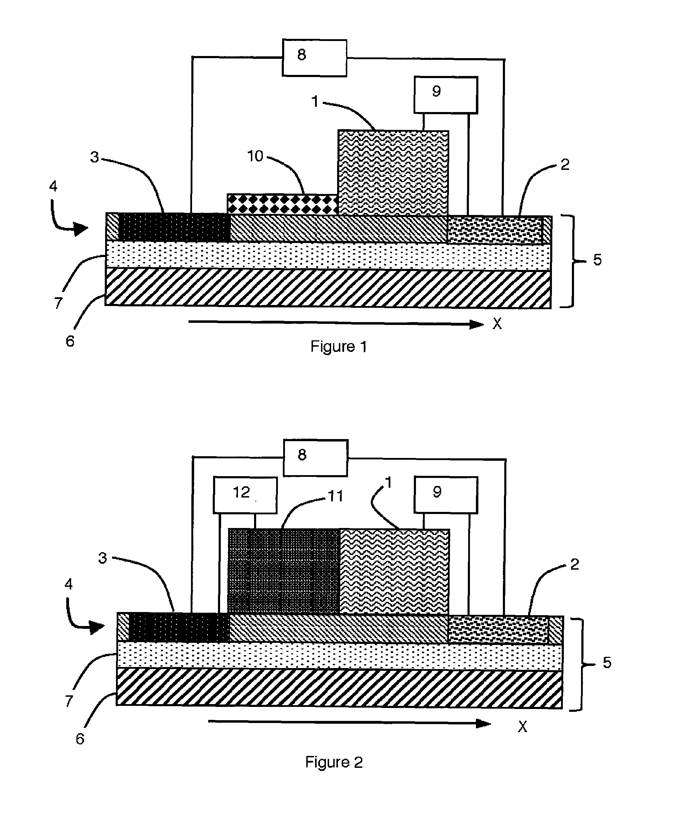

Comme illustré à la figure 1, le transistor comporte une électrode de grille 1, une première électrode de source/drain 2 et une deuxième électrode de source/drain 3. Le transistor est réalisé sur un film semi-conducteur 4, de manière préférentielle sur un substrat de type semi-conducteur sur isolant 5 qui comporte un substrat de support 6, une couche électriquement isolante 7 et le film semi-conducteur 4. Le substrat de support 6 est séparé du film semi-conducteur 4 par la couche électriquement isolante 7.

L'électrode de grille 1 est séparée du film semi-conducteur 4 par un matériau diélectrique de grille (non représenté) qui est un matériau électriquement isolant. L'électrode de grille 1 est formée par un matériau électriquement conducteur qui permet un effet électrostatique sur le film semi-conducteur 4. Les première et deuxième électrodes de source/drain 2 et 3 sont formées dans le film semi-conducteur 4 et elles sont séparées par une zone inter-électrode du film semi-conducteur 4. La zone inter-électrode est délimitée par les deux électrodes de source/drain.

La zone inter-électrode est une zone du film 4 qui présente, avantageusement, au moins une portion avec un dopage plus faible que les dopages des électrodes de source/drain 2 et 3. La zone inter-électrode est, de préférence, une zone non-intentionnellement dopée (nid), par exemple un volume du film 4 avec un dopage de type p ou n de l'ordre de 10¹⁵at/cm³. En variante, il est également possible d'avoir une zone inter-électrode plus dopée, par exemple avec des dopages de l'ordre de 10¹⁶ ou 10¹⁷at/cm³. Dans un mode de réalisation particulier illustré à la figure 1, la zone inter-électrode est une zone faiblement dopée avec un dopage uniforme depuis la première électrode 2 jusqu'à la deuxième électrode 3. Ce mode de réalisation permet l'obtention d'une bonne mobilité dans le canal de conduction qui relie les deux électrodes de source/drain 2 et 3.

Dans le film semi-conducteur 4, les électrodes de source et de drain sont séparées par un canal de conduction qui est disposé directement en dessous de l'électrode de grille 1. Le film 4 est avantageusement monocristallin pour accroître les performances électriques du transistor.

Dans certains modes de réalisation où le transistor est réalisé avec d'autres dispositifs actifs sur le film semi-conducteur 4, le transistor est isolé électriquement du reste du substrat au moyen d'un motif d'isolation (non représenté). Le motif d'isolation est réalisé dans un matériau électriquement isolant qui entoure le transistor. Le motif d'isolation s'enfonce dans le film semi-conducteur 4. Il peut également s'enfoncer dans la couche électriquement isolante 7 et dans le substrat de support 6.

La première électrode 2 de source/drain est formée dans le film semi-conducteur 4 par une première zone dopée d'un premier type de conductivité. La deuxième électrode 3 de source/drain est formée dans le film semi-conducteur 4 par une deuxième zone dopée d'un deuxième type de conductivité opposé au premier type de conductivité. Les deux électrodes de source/drain sont formées dans le film semi-conducteur 4 et elles sont décalées l'une par rapport à l'autre afin d'être séparées par la zone inter-électrode. La première électrode de source/drain 2 est, par exemple, dopée de type N et la deuxième électrode de source/drain est dopée de type P. La configuration inverse est également possible.

De manière générale, il y a donc une électrode de source/drain dopée de type N et une autre électrode de source/drain dopée de type P. A titre d'exemple, dans une couche semiconductrice du groupe IV, par exemple en silicium, en germanium ou dans un alliage de silicium-germanium, le dopage de type N est obtenu par incorporation d'arsenic ou de phosphore. Le dopage de type P est obtenu, par exemple, par incorporation de bore ou d'indium. D'autres matériaux semi-conducteurs sont envisageables comme des matériaux dits III-V ou II-VI.

Dans le transistor, il existe schématiquement une diode de type PN qui est formée par les deux électrodes de source/drain qui sont deux électrodes dopées de manières opposées. Comme la première électrode de source/drain 2 n'est pas en contact direct avec la deuxième électrode de source/drain 3, la structure n'est pas exactement celle d'une diode PN. Si la zone inter-électrode n'est pas dopée ou n'est pas intentionnellement dopée, la structure de la diode peut être assimilée à une diode de type PIN disposée dans le film semi-conducteur 4. La diode PIN est formée par les deux électrodes de source/drain 2 et 3 et par la zone inter-électrode. Si la zone inter-électrode est dopée, une structure un peu plus complexe est obtenue. La zone inter-électrode est au moins en partie recouverte par l'électrode de grille 1.

Le transistor à effet de champ comporte également un circuit de polarisation 8 de la première électrode 2 de source/drain par rapport à la deuxième l'électrode de source/drain 3 pour appliquer une première différence de potentiel entre les deux électrodes de source/drain. Le circuit de polarisation 8 est configuré de manière à polariser en direct la diode définie par les deux électrodes de source/drain, c'est-à-dire que le dispositif comporte des moyens d'application d'un potentiel plus important sur l'électrode dopée de type P que sur l'électrode dopée de type N.

En d'autres termes, le circuit de polarisation 8 est configuré de manière à ce que le potentiel appliqué sur l'électrode dopée de type P soit supérieur au potentiel appliqué sur l'électrode de type N.

La polarisation appliquée sur les deux électrodes de source/drain a pour effet de réduire l'amplitude de la barrière de potentiel qui existe dans les bandes de valence et de conduction (en l'absence de polarisation) ce qui se traduit également par l'apparition d'un courant de porteurs de charges entre les deux électrodes de source/drain.

Le dispositif peut fonctionner par enrichissement ou par déplétion. Par soucis de clarté, un seul mode de fonctionnement est décrit mais l'homme du métier aura à l'esprit que le dispositif peut être transformé pour mettre en oeuvre l'autre mode de fonctionnement.

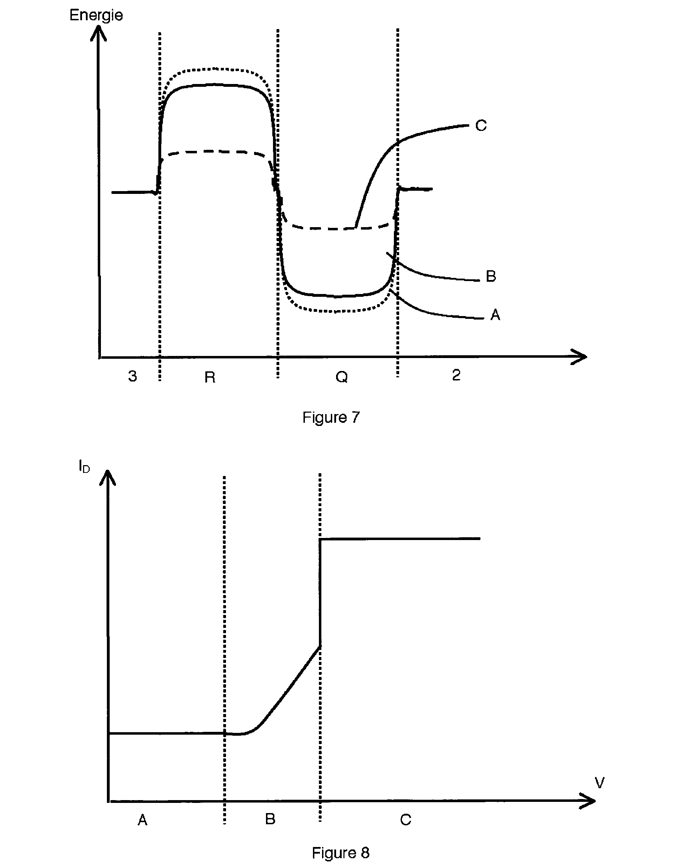

Le transistor à effet de champ comporte un premier dispositif de génération d'une première barrière de potentiel Q dans le film semi-conducteur 4 et un deuxième dispositif de génération d'une deuxième barrière de potentiel R dans le film semi-conducteur 4 (figure 7). Les première et deuxième barrières de potentiel sont décalées latéralement l'une de l'autre, c'est-à-dire qu'elles sont disposées en série dans une direction X qui relie la première électrode 2 de source/drain à la deuxième électrode 3 de source/drain. La première barrière de potentiel Q est disposée adjacente à la première électrode 2 de source/drain et la deuxième barrière de potentiel R est disposée adjacente à la deuxième électrode 3 de source/drain. De cette manière, la deuxième barrière de potentiel R est séparée de la première électrode 2 par la première barrière de potentiel Q et la première barrière de potentiel Q est séparée de la deuxième électrode 3 par la deuxième barrière de potentiel R selon l'axe X.

La première barrière de potentiel Q est configurée pour s'opposer au passage des charges électriques émises par la première électrode 2 de source/drain en direction de la deuxième électrode 3. La deuxième barrière de potentiel R est configurée pour s'opposer au passage des charges électriques émises par la deuxième électrode 3 de source/drain en direction de la première électrode 2. Une barrière de potentiel représente un minimum ou un maximum local de l'énergie dans la bande de conduction ou dans la bande de valence.

De cette manière, si la première électrode 2 est dopée de type N, la première barrière de potentiel Q dans la bande de conduction s'oppose au passage des électrons émis par l'électrode 2 en direction de la deuxième électrode 3 et la deuxième barrière de potentiel R dans la bande de valence s'oppose au passage des trous d'électrons émis par la deuxième électrode 3 en direction de la première électrode 2.

Dans le cas où la première électrode 2 est dopée de type P, la première barrière de potentiel Q dans la bande de valence s'oppose au passage des trous d'électrons émis par l'électrode 2 en direction de la deuxième électrode 3 et la deuxième barrière de potentiel R, dans la bande de conduction, s'oppose au passage des électrons émis par la deuxième électrode 3 en direction de la première électrode 2.

Le premier circuit de polarisation ou le deuxième circuit de polarisation est un circuit de polarisation à amplitude variable. De cette manière, l'amplitude de la première barrière de potentiel Q ou de la deuxième barrière de potentiel R peut être modulée en fonction de la consigne appliquée par le circuit de polarisation associé. Cette modulation d'une des barrières de potentiel permet de définir la quantité de courant qui transite à l'intérieur du transistor et donc de définir un état passant et un état bloqué.

Les première et deuxième barrières de potentiel peuvent être obtenues au moyen de différentes techniques, par exemple au moyen de différents dispositifs de commande électrostatique qui sont disposés face à la zone inter-électrode, c'est-à-dire pour recouvrir au moins partiellement la zone inter-électrode dans l'axe X reliant les deux électrodes 2 et 3. Il est également possible de former une barrière de potentiel au moyen des propriétés électroniques du matériau formant une partie de la zone inter-électrode sans utiliser de dispositif électrostatique.

Différents modes de réalisation du transistor de la cellule mémoire sont illustrés ci-dessous à titre d'exemple. D'autres transistors peuvent être utilisés dans la mesure où ils comportent deux dispositif de génération des première et deuxième barrières de potentiel, une électrode de grille 1 reliée à une source de tension et une diode de type PN formée par les deux électrodes de source/drain.

Dans un mode de réalisation préférentiel illustré à la figure 1, le circuit de polarisation à amplitude variable comporte un circuit de polarisation 9 de l'électrode de grille 1. Le circuit de polarisation 9 de l'électrode de grille 1 est alors configuré de manière à générer, face à l'électrode de grille 1, la première barrière de potentiel Q. Cette barrière de potentiel tend à s'opposer au passage des porteurs de charges émis par l'électrode de source/drain la plus proche. De cette manière, la répartition des potentiels dans le film semi-conducteur 4 tend à réduire la probabilité qu'une charge électrique transite entre les électrodes de source et de drain. Il est également possible de considérer que le circuit de polarisation 9 de l'électrode de grille 1 est configuré de manière à générer, face à l'électrode de grille, la deuxième barrière de potentiel R, ce qui a été dit pour la première barrière peut être appliqué à la deuxième barrière et inversement.

Ainsi, lorsque l'électrode de grille 1 est localisée adjacente à la première électrode 2 de source/drain, c'est-à-dire lorsque l'électrode de grille 1 est plus proche de la première électrode 2 que de la deuxième électrode 3, deux cas de figure sont possibles. Le circuit de polarisation 9 de l'électrode de grille 1 est configuré de manière à ce que le potentiel de l'électrode de grille 1 soit inférieur au potentiel de la première électrode 2 lorsque la première électrode est dopée de type P. Le circuit de polarisation 9 de l'électrode de grille 1 est configuré de manière à ce que le potentiel de l'électrode de grille 1 soit supérieur au potentiel de la première électrode 2 lorsque la première électrode 2 est dopée de type N.

Dans le reste de la description, l'électrode de grille 1 est considérée adjacente à la première électrode 2 comme cela est représenté sur les différentes figures, mais il est également possible d'avoir l'électrode de grille 1 adjacente à la deuxième électrode 3 ce qui entraîne un basculement de position des différents éléments décrits.

Dans ce mode de réalisation, l'autre barrière de potentiel (ici, la deuxième barrière de potentiel) peut être définie avec des moyens de commande appliquant une polarisation, par exemple constante. L'autre barrière de potentiel peut également être définie au moyen de la modulation des propriétés des bandes énergies par des charges électriques fixes disposées à proximité du film semi-conducteur ou au moyen de la modulation des propriétés des bandes d'énergies dans la zone inter-électrode.

Dans un mode de réalisation particulier illustré à la figure 1, l'autre barrière de potentiel provient de charges électriques présentes à l'interface entre le film semi-conducteur 4 et un film isolant de recouvrement 10 ou présentes dans le film électriquement isolant 10. Le film isolant de recouvrement 10 recouvre au moins partiellement la zone située entre l'électrode de grille 1 et la deuxième électrode 3. Ce matériau électriquement isolant comporte des charges électriques emprisonnées tout en restant électriquement isolant. Il est encore possible de placer des liaisons chimiques pendantes à l'interface avec le film 4 de manière à générer des charges électriques. Le procédé de réalisation choisi permet de moduler la quantité de charges électriques présentes à l'interface. Par exemple, il est possible de déposer un oxyde de silicium comportant des charges électriques positives au moyen d'un dépôt chimique en phase vapeur. Dans ce cas, il y a deux dispositifs de modulation du niveau des bandes d'énergie dans le film semi-conducteur 4 par effet électrostatique. Ces deux commandes électrostatiques sont faces à la zone inter-électrode et elles sont décalées, selon l'axe X, l'une par rapport à l'autre pour générer deux barrières de potentiel distinctes. Une des commandes électrostatiques est variable en amplitude, l'électrode de grille 1. L'autre commande électrostatique est constante comme cela peut être le cas avec les charges électriques associées au film de recouvrement 10.

Dans un autre mode de réalisation illustré à la figure 2 qui peut être combiné avec le mode précédent, l'autre barrière de potentiel est introduite au moyen d'une électrode de grille additionnelle 11 qui est disposée adjacente à l'électrode de grille 1. Les deux électrodes de grille recouvrent la zone inter-électrode et génèrent deux barrières de potentiel distinctes. L'électrode de grille additionnelle 11 est connectée à un circuit de polarisation 12 de l'électrode additionnelle qui est configuré pour générer la deuxième barrière de potentiel. L'électrode de grille additionnelle est séparée électriquement du film semi-conducteur 4 par un matériau électriquement isolant. L'électrode de grille 1 et l'électrode de grille additionnelle 11 sont disposées du même côté du film semi-conducteur 4. Les deux électrodes de grille sont dissociées électriquement.

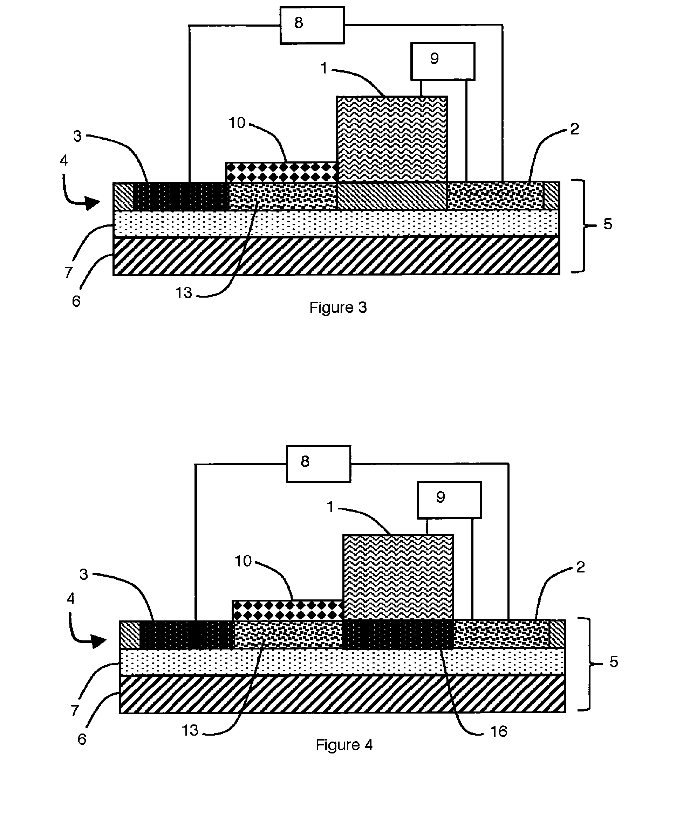

Dans un autre mode de réalisation illustré à la figure 3 qui peut être combiné avec les modes précédents, la deuxième barrière de potentiel est introduite au moyen d'une zone dopée additionnelle 13 localisée entre les deux électrodes de source/drain 2 et 3 dans le film semi-conducteur 4. La zone dopée additionnelle 13 est disposée à proximité de l'électrode de source ou de l'électrode de drain et son type de dopage est choisi de manière à former une jonction de type PN avec l'électrode la plus proche. Ainsi, la zone additionnelle 13 est de type N si elle est placée à proximité de l'électrode de source/drain dopée de type P. Au contraire, la zone additionnelle 13 est de type P si elle est placée à proximité de l'électrode de source/drain dopée de type N. L'utilisation de la zone dopée 13 permet de réduire la variabilité de la valeur de la barrière en utilisant un matériau dont le positionnement des bandes de valence et de conduction est connu. Utiliser la zone 13 permet également de s'affranchir d'une source de polarisation pour former la deuxième barrière de potentiel.

Dans le mode de réalisation illustré à la figure 3, l'électrode de grille 1 est placée à côté de la première électrode 2 et la zone dopée additionnelle 13 est placée à côté de la deuxième électrode 3. La zone dopée additionnelle 13 est dopée de la même manière que la première électrode 2. De manière générale, la zone dopée 13 comporte un dopage de type opposé à celui de son électrode la plus proche de manière à former une jonction PN dans le même sens que la jonction PN formée par la première électrode 2 et la deuxième électrode 3. La structure du film semi-conducteur peut être en partant de l'électrode 2 pour arriver à l'électrode 3, de type PIPN, NINP, PNPN ou NPNP. Les électrodes 2 et 3 sont de types opposés et entre ces deux électrodes, différents arrangements sont possibles ce qui peut aboutir à l'utilisation de deux diodes PN ou NP en série ou à l'utilisation d'une diode PIN avec une zone dopée placée entre la zone intrinsèque et l'électrode 2 ou 3 pour former une diode additionnelle.

Dans l'exemple particulier illustré à la figure 4, la zone dopée additionnelle 13 est associée à une zone dopée complémentaire 16. Dans ce cas de figure particulier, le film semi-conducteur 4 comporte deux diodes de type PN ou NP montées en série entre les deux électrodes 2 et 3. Les deux diodes sont orientées dans le même sens de manière à avoir la structure PNPN ou NPNP. Les bornes extrêmes de cet empilement sont formées par les première ou deuxième électrodes 2, 3.

Ces différents modes de réalisation particuliers illustrent en plus le fait que le dispositif peut fonctionner par enrichissement ou par déplétion.

La zone dopée additionnelle 13 est avantageusement formée sur un substrat de type semi-conducteur sur isolant. De manière préférentielle, la zone dopée additionnelle 13 s'étend sur toute l'épaisseur du film semi-conducteur 4, c'est-à-dire depuis la surface en contact avec la couche électriquement isolante jusqu'à la surface opposée qui est recouverte par le diélectrique de grille.

Comme cela est indiqué plus haut, la zone additionnelle 13 peut être associée à la couche de recouvrement 10 et/ou à une électrode de grille additionnelle 11 afin de cumuler les effets.

La modulation d'amplitude d'une des deux barrières de potentiel permet de commander la quantité de courant traversant le transistor. La modulation d'amplitude dans les deux barrières permet également d'obtenir cet effet et de définir le basculement entre les états bloqué et passant. Le dispositif profite de la rétroaction positive qui existe entre les deux barrières de potentiel. Ainsi, lorsque l'une des barrières de potentiel voit son amplitude diminuer (en valeur absolue), il en va de même pour l'autre barrière de potentiel.

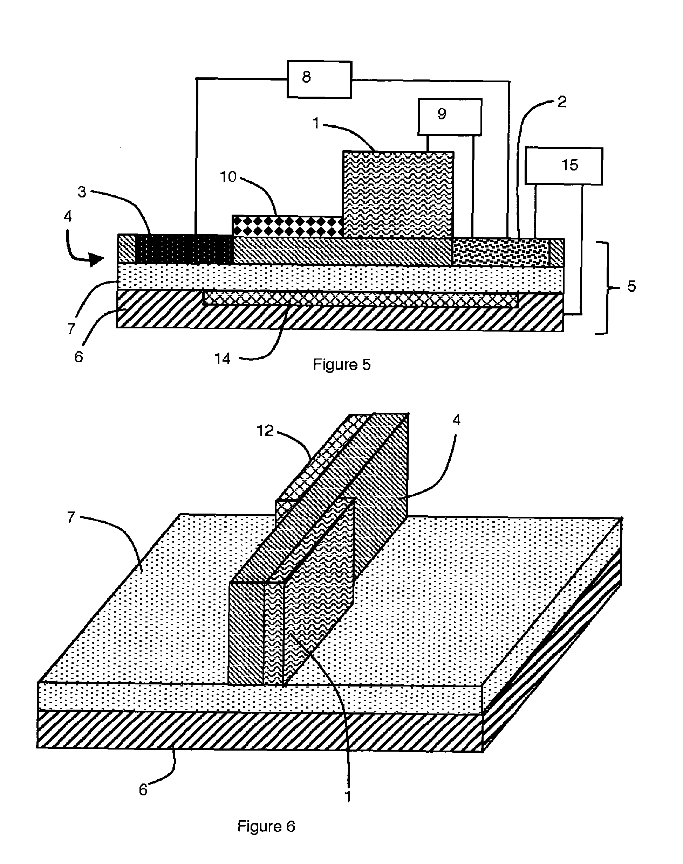

Dans un autre mode de réalisation illustré à la figure 5 qui peut être combiné avec les modes de réalisation précédents, le substrat comportant le dispositif à effet de champ est un substrat de type semi-conducteur sur isolant 5 avec une contre-électrode 14. La contre-électrode 14 est séparée du film semi-conducteur 4 par la couche électriquement isolante 7. La contre-électrode 14 fait face à au moins une partie de la zone inter-électrode. La contre-électrode 14 peut également faire face à au moins une partie de l'électrode de grille 1. Le dispositif comporte alors un circuit de polarisation 15 de la contre-électrode 14 qui est configuré de manière à créer une différence de potentiel entre la première électrode 2 et la contre-électrode 14 qui est de même signe que la différence de potentiel existante entre la première électrode 2 et l'électrode de grille 1 que la première électrode 2 soit dopée P ou N.

En d'autres termes, le circuit de polarisation 15 de la contre-électrode 14 est configuré pour présenter une différence de potentiel entre l'électrode dopée de type N et la contre-électrode 14 qui est de même signe que la différence de potentiel entre l'électrode dopée de type N et l'électrode de grille 1 lorsque l'électrode de grille 1 est localisée du côté N. Le circuit de polarisation 15 de la contre-électrode 14 est configuré pour présenter une différence de potentiel entre l'électrode dopée de type P et la contre-électrode 14 qui est de même signe que la différence de potentiel entre l'électrode dopée de type P et l'électrode de grille 1 lorsque l'électrode de grille 1 est localisée du côté P.

La contre-électrode 14 peut être face à l'électrode de grille 1. Il existe une différence de dimension entre les deux électrodes 1 et 14 selon l'axe X de manière à pouvoir générer deux barrières de potentiel qui sont décalées selon l'axe X et qui sont orientées dans des directions opposées de potentiel.

La contre-électrode 14 peut encore être décalée par rapport à la première électrode de grille 1 afin de réduire, voire d'éviter un recouvrement des forces électrostatiques appliquées.

De manière générale, les première et deuxième barrières de potentiel générées dans le film semi-conducteur empêchent le passage des porteurs de charge entre les première et deuxième électrodes 2 et 3. Dans cette configuration un courant très faible (courant à l'état OFF) circule entre les première et deuxième électrodes, c'est-à-dire un courant parasite.

La modulation de l'amplitude de la première barrière peut être obtenue au moyen du potentiel appliqué sur l'électrode de grille 1 ou au moyen du potentiel appliqué sur la contre-électrode 14 ou par une combinaison de ces deux paramètres.

Il est également envisageable d'avoir une différence de potentiel fixe entre l'électrode de grille 1 et la contre-électrode 14, la modulation de l'amplitude de la barrière étant seulement réalisée au moyen de la contre-électrode 14 dans la zone dépourvue de recouvrement par l'électrode de grille 1. La contre-électrode a la fonction d'électrode de grille qui génère une première barrière de potentiel. Il y a en plus un dispositif de génération d'une deuxième barrière de potentiel qui s'oppose à l'effet électrostatique induit par la contre-électrode 14.

Dans encore une autre variante de réalisation non représentée, la contre-électrode 14 est disposée entre les deux électrodes de source/drain ce qui permet de générer une première barrière de potentiel Q dans le film 4 entre les deux électrodes 2 et 3. L'électrode de grille 1 est disposée à proximité d'une des deux électrodes afin de générer la deuxième barrière de potentiel R.

Dans un autre mode de réalisation illustré à la figure 6, le premier dispositif de génération de la première barrière de potentiel Q dans le film semi-conducteur 4 et le deuxième dispositif de génération de la deuxième barrière de potentiel R dans le film semi-conducteur 4 sont disposés de part et d'autre du film semi-conducteur 4.

Le film semi-conducteur 4 est un motif qui fait saillie depuis un film électriquement isolant. Le film électriquement conducteur comporte deux faces principales opposées et au moins une face latérale qui relie les deux faces principales. La face latérale a une interface avec la couche électriquement isolante 7. Le dispositif peut donc être formé sur un substrat de type semi-conducteur sur isolant mais dans une configuration différente de celle représentée à la figure 3. Alors que les modes de réalisation précédents permettaient une co-intégration avec des transistors selon une architecture dite « planaire », ce dernier mode de réalisation permet la co-intégration avec des transistors selon une architecture dite « FinFet ». La différence entre ce type de dispositif et un transistor conventionnel provient du dopage des électrodes de source et drain et dans la surface de recouvrement de l'électrode de grille.

Il est également possible de réaliser le transistor à effet de champ, dans une architecture dite « double grille », par exemple au moyen d'un canal semi-conducteur qui est suspendu ou disposé au-dessus du substrat semi-conducteur. Les deux grilles sont séparées par le film semi-conducteur 4. Dans ce cas de figure, le substrat de type semi-conducteur sur isolant n'est pas obligatoire. Comme pour le mode de réalisation précédent, la différence entre ce type de dispositif et un transistor conventionnel provient du dopage des électrodes de source et drain et dans la surface de recouvrement de l'électrode de grille.

L'électrode de grille 1 est formée sur une des faces principales et le deuxième dispositif de génération de la deuxième barrière de potentiel R est formé sur l'autre face principale. Le deuxième dispositif peut être formé par le film de recouvrement 10 ou, avantageusement, par une deuxième électrode de grille qui fait office de contre-électrode 12. Dans ce mode de réalisation, il existe une grande liberté dans le choix du matériau formant le diélectrique de grille ainsi que dans l'épaisseur formée.

Les modes de réalisation indiqués plus haut et illustrés par exemple aux figures 1 et 2 peuvent être combinés à ce mode de réalisation. Les deux dispositifs de génération des barrières de potentiels peuvent être du même côté du film 4, c'est-à-dire sur la même face principale ou sur des faces principales opposées.

Dans les modes de réalisation particuliers illustrés aux figures 1 à 6, la surface qui sépare la première électrode 2 de source/drain de la deuxième électrode 3 de source/drain n'est pas complètement recouverte par l'électrode de grille 1. Ainsi, dans un axe X qui relie les deux électrodes de source/drain, une partie de la distance parcourue par les porteurs de charge est recouverte par l'électrode de grille 1 et une autre partie est dépourvue de cette couverture de sorte que cette autre partie ne subit pas l'influence électrostatique de l'électrode de grille 1. De cette manière, il existe au-dessus de la zone définie par les électrodes de source et de drain, une portion recouverte par l'électrode de grille 1 et une portion qui est recouverte par un matériau diélectrique dépourvu d'électrode de grille 1 ou une partie qui n'est pas recouverte par un matériau à l'état solide ou liquide. La structure est dite asymétrique car l'électrode de grille 1 n'est pas disposée à équidistance des deux électrodes de source/drain 2 et 3 dans une vue de dessus ou une vue de coupe. Il en est de même lorsque la contre-électrode 14 ne recouvre pas toute la distance inter-électrode ou lorsqu'elle n'est pas disposée à équidistance entre les deux électrodes 2 et 3.

De manière préférentielle, l'électrode de grille 1 est localisée au-dessus de la zone inter-électrode de manière à ce qu'une de ses parois latérales se trouve immédiatement adjacente d'une des deux électrodes de source/drain ou de manière à légèrement recouvrir la première électrode 2. Dans cette configuration, une des parois latérales de l'électrode de grille est alignée avec l'interface entre la première électrode 2 et la zone inter-électrode. Cette configuration particulière permet d'obtenir une bonne compacité du transistor. L'électrode de grille 1 est donc localisée du coté N du dispositif (c'est-à-dire à proximité immédiate de l'électrode dopée N) ou du coté P du dispositif (c'est-à-dire à proximité immédiate de l'électrode dopée P).

La figure 7 représente l'évolution du potentiel de la bande de valence ou de la bande de conduction à l'intérieur du transistor pour plusieurs conditions de polarisation. La figure 8 représente le courant I_{D} qui circule entre la première électrode 2 et la deuxième électrode 3 en fonction de la différence de potentiel appliquée, par exemple, entre la première électrode 2 et l'électrode de grille 1.

La figure 7 représente la bande de valence ou la bande de conduction dans la première électrode de source/drain 2, dans la première barrière de potentiel Q, dans la deuxième barrière de potentiel R et dans la deuxième électrode de source/drain 3. La figure 7 sera décrite en considérant que le terme bande d'énergie se réfère à la bande de valence ou à la bande de conduction selon le type de porteur considéré. L'exemple illustré correspond à une électrode de grille 1 placée à proximité d'une première électrode 2 dopée de type N. Les valeurs des potentiels sont inversées si la première électrode 2 est dopée de type P.

La différence de potentiel appliquée entre la première électrode de source/drain 2 et la deuxième électrode de source/drain 3 est configurée de manière à passer en direct la diode qui existe entre les deux électrodes 2 et 3 ce qui se traduit par un rapprochement des niveaux de potentiel de la bande d'énergie entre la première et la deuxième électrodes. Dans le cas présent, le potentiel appliqué sur la deuxième électrode 3 est supérieur au potentiel appliqué sur la première électrode 2. Dans l'exemple de la figure 7, les niveaux de la bande d'énergie sont identiques pour les deux électrodes de source/drain, mais des barrières différentes peuvent être envisageables.

Le potentiel appliqué sur l'électrode de grille 1 génère la première barrière de potentiel Q qui s'oppose à la migration des électrons vers l'électrode 3 de type P. La deuxième barrière de potentiel est de sens opposé et elle s'oppose à la migration de trous d'électrons depuis l'électrode 3 de type P vers l'électrode 2 dopée N. Cette situation est représentée schématiquement par la courbe A.

Dans cette configuration un très faible courant circule entre les deux électrodes de source/drain comme cela est représenté à la figure 8 dans la partie A.

Le potentiel appliqué sur l'électrode de grille 1 évolue de manière à réduire l'amplitude de la première barrière de potentiel Q ce qui entraine une augmentation de la probabilité de passage des charges émises par la première électrode 2 et donc une augmentation légère de la valeur du courant. Les charges émises depuis la première électrode 2 atteignent la seconde électrode 3 ce qui modifie la valeur de l'amplitude de la barrière de potentiel R, cela permet l'émission de charges électriques dans l'autre sens. Cette diminution de l'amplitude des deux barrières de potentiel est représentée par la courbe B.

Comme cela est illustré à la figure 8, dans la partie B, au fur et à mesure de la diminution de la valeur de l'amplitude de la première barrière de potentiel, la valeur du courant I_{D} circulant à l'intérieur du transistor augmente. A partir d'un moment où le potentiel de grille 1 atteint une valeur seuil, les charges électriques émises par la première électrode et passant la première barrière de potentiel Q sont en mesure de créer une diminution de l'amplitude de la deuxième barrière de potentiel R et un courant important depuis la deuxième électrode 3 vers la première électrode 2. Les deux courants de charges électriques entrainent chacun une diminution des deux barrières de potentiel de sorte qu'un courant important se met à circuler brusquement à l'intérieur du transistor comme cela est représenté dans la zone C de la figure 8.

Comme cela est visible sur la figure 7, lors du passage du courant dans le transistor à l'état passant, les barrières de potentiel Q et R sont réduites en amplitude.

Des mesures électriques ont été réalisées sur un dispositif et le courant parasite mesuré à l'état bloqué est inférieur ou égal à 10⁻¹³A/µm (régime A). Le courant circulant à l'état passant (régime C) évolue entre 10⁻⁸ et 10⁻³ A/µm selon les conditions de polarisations de la diode. L'inverse de la pente sous le seuil de cette architecture particulière est meilleure à ce qui est mesuré classiquement pour les transistors conventionnels (environ 1mV/décade contre 60mv/décade pour l'art antérieur).

Par ailleurs, le transistor fonctionne avec la diode en polarisation directe et avec une maîtrise du flux de porteurs de charge au moyen de deux barrières de potentiel de sens opposés. Dans son utilisation, le transistor n'utilise pas un fonctionnement par ionisation par impact ou un fonctionnement par effet tunnel, deux phénomènes qui sont néfastes pour une bonne tenue dans le temps des performances du dispositif.

Un circuit de commande est associé au transistor pour former la cellule mémoire dynamique.

Le circuit de commande associé au transistor est configuré pour polariser le transistor de manière à écrire un premier état, à écrire un deuxième état, à lire l'état stocké dans la cellule mémoire, c'est-à-dire l'information stockée dans le transistor et à réinitialiser la cellule mémoire. De manière arbitraire, dans les exemples qui vont suivre, l'électrode de source est considérée placée à un potentiel fixe afin de décrire simplement les différences de potentiels qui existent entre les électrodes du transistor lors des multiples opérations d'écriture, lecture et initialisation. L'homme du métier gardera à l'esprit que le positionnement des potentiels appliqués sur les différentes électrodes permet d'obtenir le fonctionnement recherché. L'électrode de grille commande la première barrière de potentiel et elle est placée, ici, adjacente à l'électrode de drain.

A titre d'exemple, l'électrode de source est considérée connectée à la masse. Les informations numériques données ci-dessous correspondent aux valeurs mesurées expérimentalement sur un transistor formé sur un substrat de type silicium sur isolant avec une couche électriquement isolante 7 en oxyde de silicium d'une épaisseur égale à 140nm. Le diélectrique de grille est un oxyde de silicium ayant une épaisseur égale à 6nm formé sur une couche 4 de silicium dont l'épaisseur est égale à 20nm. La longueur de l'électrode de grille est égale à 400nm, la largeur de l'électrode de grille est égale à 10µm. Les électrodes de source et de drain sont distantes de 600nm et il n'y a pas de recouvrement entre les deux dispositifs de génération des barrières de potentiel.

Les dimensions d'un tel dispositif correspondent à une version d'évaluation et l'homme du métier gardera à l'esprit qu'un tel dispositif peut présenter des dimensions plus réduites afin de suivre la tendance actuelle à la miniaturisation. Un dispositif de l'ordre de 70nm peut être obtenu aisément de manière industrielle. Au fur et à mesure de sa miniaturisation, les tensions appliquées pour les phases d'écriture, de lecture et de maintien de l'information stockée peuvent également diminuer afin d'être de l'ordre de 1 Volt.

La première barrière de potentiel est commandée par l'électrode de grille et la deuxième barrière de potentiel n'est pas modulée depuis l'extérieur dans les exemples suivants. L'écriture du premier état, par exemple l'état bas de la cellule, correspond à la réinitialisation (RESET en anglais) de la cellule mémoire. L'écriture de ce premier état est réalisée en laissant la diode présente entre les électrodes de source et de drain à l'état bloqué, c'est-à-dire que la diode ne laisse pas passer ou presque pas passer de courant. La polarisation appliquée entre l'électrode de source et de drain est inférieure à 0,5V en polarisation directe, c'est à dire que la diode peut ne pas être polarisée (une polarisation nulle à ses bornes) ou qu'une polarisation inverse est appliquée entre les deux électrodes de source/drain. De manière préférentielle, la différence de potentiel appliquée entre les électrodes de source et de drain est configurée de manière à ce qu'aucun courant ne circule entre les deux électrodes, la diode est alors dans un état bloquant.

Le circuit de commande est également configuré de manière à initialiser le condensateur qui est défini par le diélectrique de grille. Une des électrodes du condensateur est formée par l'électrode de grille et l'autre électrode est formée par la partie du film 4 semi-conducteur qui fait face à l'électrode de grille. Plus particulièrement, la partie du film 4 adjacente à l'électrode de drain forme ici une électrode du condensateur. Le potentiel appliqué sur l'électrode de grille 1 est configuré de manière à décharger le condensateur. Le potentiel est configuré de manière à ce qu'une différence de potentiel nulle ou sensiblement nulle existe entre les deux électrodes du condensateur, c'est-à-dire entre l'électrode de grille 1 et le film 4 directement sous l'électrode de grille 1.

Dans un mode de réalisation particulier, la cellule mémoire est configurée de manière à ce qu'une différence de potentiel nulle soit présente entre l'électrode de grille et l'électrode de source/drain adjacente, ici l'électrode de drain ce qui permet de fortement diminuer la quantité de charges électriques présentes dans le condensateur.

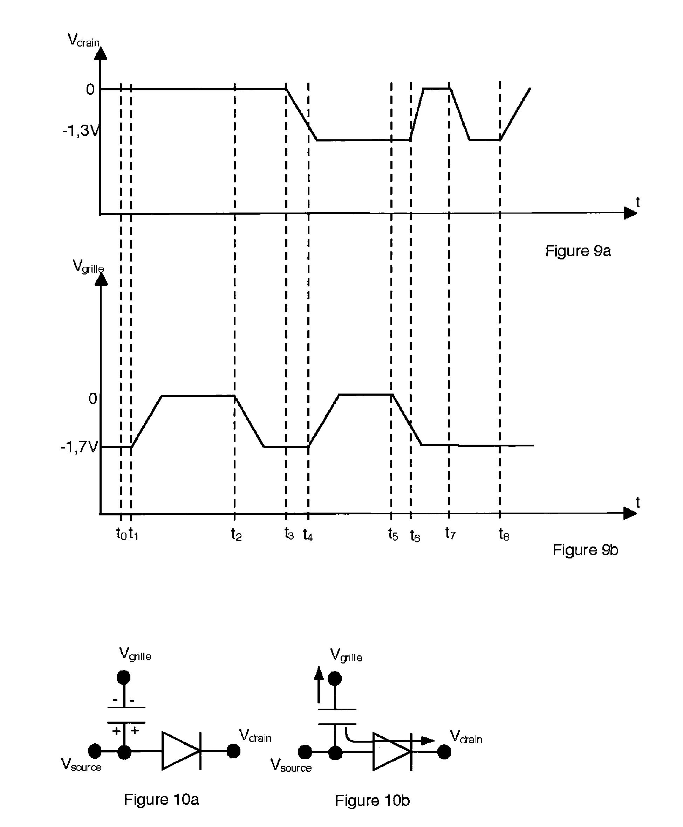

La figure 9a représente un chronogramme de la tension de drain. La figure 9b représente un chronogramme de la tension de grille. La phase d'initialisation de la cellule mémoire est représentée entre les instants t₀ et t₂. A un instant t₀, la tension de drain est choisie de manière à faire passer la diode à l'état bloqué. Puis à un instant t₁, la tension de grille est modifiée de manière à initialiser le condensateur formé par l'électrode de grille et le film 4, par exemple de manière à avoir une différence de potentiel nulle entre les deux électrodes du condensateur. A partir de l'instant t₁, les charges éventuellement présentes dans la cellule mémoire sont évacuées.

A un instant t₂, le condensateur est déchargé et la tension de grille peut être modifiée, par exemple pour retrouver la même valeur qu'avant l'instant t₁. La tension de grille est avantageusement modifiée pour placer la cellule mémoire dans une phase de maintien de l'état imposé, ici pour stocker une absence de charge dans le condensateur. Cependant, dans certains modes de fonctionnement, la tension de grille peut être égale à la valeur présente par exemple à l'instant t₀ ou elle peut être conservée en fonction de la prochaine action prévue pour la cellule mémoire.

Les figures 10a et 10b représentent schématiquement le transistor illustré aux figures 1 à 6 avec la diode formée entre les électrodes de source et de drain et le condensateur formé par l'électrode de grille et le film 4. La deuxième grille ou le dispositif de génération de la deuxième barrière de potentiel n'est pas représenté. La phase d'initialisation de la cellule mémoire permet de passer d'un transistor selon la figure 10a à un transistor selon la figure 10b. La figure 10a représente une cellule mémoire dans le deuxième état, c'est-à-dire avec des charges électriques stockées dans le condensateur. La polarisation appliquée entre les électrodes de source et de drain est choisie de manière à avoir la diode à l'état bloquant. Lorsque la différence de potentiel aux bornes du condensateur s'annule, les charges de chacune des électrodes sont évacuées comme cela est représenté schématiquement par les flèches de la figure 10b. L'évacuation des charges est réalisée, par exemple en appliquant un potentiel nul sur l'électrode de grille et sur l'électrode de drain (l'électrode de source étant également au potentiel nul par convention).

A titre d'exemple particulièrement avantageux à mettre en oeuvre, si une différence de potentiel nulle est appliquée entre les électrodes de source et de drain, il suffit d'appliquer une différence de potentiel nulle entre les électrodes de source et de grille. Les électrodes de source, de drain et de grille sont toutes au même potentiel.

L'écriture du deuxième état de la cellule mémoire est réalisée en polarisant le transistor de manière à le mettre à l'état passant. Le circuit de commande est configuré de manière à polariser en direct la diode définie par les deux électrodes de source/drain, c'est-à-dire que le circuit de commande est configuré de manière à appliquer une première différence de potentiel entre les électrodes de source et drain configurée pour que le potentiel appliqué sur l'électrode dopée de type P soit supérieur au potentiel appliqué sur l'électrode de type N. La différence de potentiel appliquée entre les électrodes de source et de drain est configurée pour permettre le passage d'un courant supérieur à un seuil, ce seuil est atteint par exemple avec une différence de potentiel supérieure à 0,5V.

Le circuit de commande est également configuré de manière à appliquer un potentiel sur l'électrode de grille 1 ou des potentiels sur l'électrode de grille 1 et sur la contre-électrode 11, 12 ou 14 qui permettent le passage d'un courant de porteurs de charges entre les électrodes de source et de drain. Durant l'écriture du deuxième état, il y a passage d'un courant entre les électrodes de source et de drain. Il y alors présence de trous d'électrons et d'électrons en excès dans le canal.

Sur la figure 9a, à un instant t₃, le potentiel de drain est modifié de manière à faire basculer la diode à l'état passant. Sur la figure 9b, à un instant t₄, le potentiel de grille est modifié de manière à réduire les barrières de potentiel ce qui permet le passage d'un courant entre les électrodes de source et de drain quand la diode est à l'état passant.

Selon les modes de réalisation, les instants t₃ et t₄ peuvent être décalés l'un par rapport à l'autre dans un sens ou dans l'autre ou encore être simultanés.

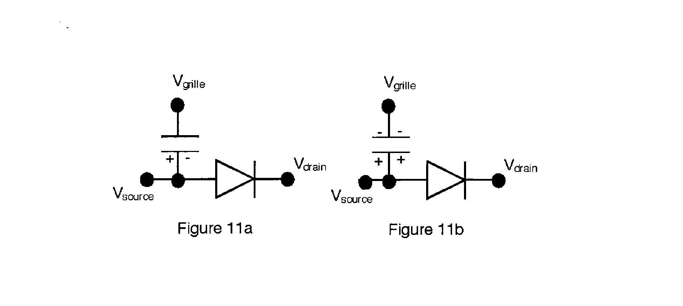

Une fois que le transistor est à l'état passant, les porteurs de charges en excès sont présents dans le canal comme cela est représenté sur la figure 11 a qui utilise la même schématique que les figures 10a et 10b. La phase d'écriture d'un deuxième état est réalisée schématiquement en passant du transistor de la figure 11a à celui de la figure 11 b.

Sur la figure 9b, à un instant t₅, le potentiel de grille est modifié pour passer le transistor à l'état bloquant. Les charges excédentaires dans le canal sont stockées dans le condensateur comme cela est représenté sur la figure 11 b. Au même instant ou après l'instant t₅, par exemple à l'instant t₆, le potentiel de drain est modifié pour basculer la diode à l'état bloqué.

Le potentiel de drain est modifié avant ou simultanément au potentiel de grille afin d'éviter que la phase d'écriture du deuxième état soit immédiatement suivie de la phase d'écriture d'un premier état ce qui correspond à une initialisation de la cellule mémoire. En d'autres termes, durant la phase d'écriture du deuxième état, une fois que le transistor est devenu passant, il faut bloquer à nouveau le transistor au moyen des barrières de potentiels. Ensuite, de manière avantageuse, le maintien de l'information dans la cellule mémoire est obtenue en passant la diode à l'état bloqué.

A titre d'exemple, lorsque l'électrode de drain est dopée de type N, c'est-à-dire que l'électrode de grille est immédiatement adjacente à l'électrode dopée N, l'état passant est obtenu en appliquant un potentiel égal à -1,3V sur l'électrode de drain et un potentiel égal à -1,7V sur l'électrode de grille comme cela est représenté sur les figures 9a et 9b. L'électrode de source est connectée à la masse.

Avec un tel dispositif, la durée de programmation d'un premier état ou d'un deuxième état peut être réduite à 1 ns.

L'opération de maintien ou de stockage des premier et second états de la cellule mémoire est réalisée en repassant le transistor à l'état bloqué au moyen de la diode et des barrières de potentiels. De ce fait, la différence de potentiel entre les électrodes de source et de drain peut être nulle ou représentative d'une polarisation en inverse de la diode ou d'une polarisation directe de la diode avec une différence de potentiel inférieure à 0,5V. Le circuit de commande est donc configuré dans ce sens. Le circuit de commande est également configuré de manière à ce que la barrière de potentiel commandée par l'électrode de grille 1 soit présente de manière à figer l'état du canal après l'étape d'écriture du premier ou du second état. De plus, il existe une différence de potentiel entre les bornes du condensateur de manière à conserver les charges stockées. Le circuit de commande est configuré pour que, lors de la phase de maintien de l'information, la différence de potentiel entre l'électrode de grille et l'électrode source soit de même signe que la différence de potentiel imposée entre l'électrode de drain et l'électrode de source pour avoir une diode à l'état passant (ici V_{DS} et V_{GS} sont négatifs). Durant la phase de maintien, il n'y a pas de courant qui traverse le transistor.

Lors de l'écriture du second état, les porteurs de charge sont injectés dans le canal et le passage à l'étape de maintien de l'information permet de stocker des porteurs de charges dans la barrière de potentiel commandée par l'électrode de grille 1. Comme les porteurs de charge accumulés dans le canal sont dans un état d'équilibre, ces charges ne sont pas perdues ce qui fait que ce deuxième état ne demande pas de rafraîchissement.

Lors de l'écriture du premier état, les charges électriques présentes aux bornes du condensateur défini par le diélectrique de grille ont été éliminées, il n'y a pas de porteurs de charge à stocker dans la barrière de potentiel. La tension appliquée sur l'électrode de grille essaye de charger le condensateur. Comme le courant de fuite de la jonction entre le drain et le canal polarisée en inverse est très faible, il n'y a pas de charge du condensateur. Le temps de rétention de cette information est important, mais il reste conditionné par les imperfections technologiques de réalisation, notamment par la qualité de la jonction drain/canal polarisée en inverse.

Dans l'exemple illustré plus haut, des trous d'électrons sont stockés dans le canal face à l'électrode de grille 1 pour le second état. Le stockage de l'information peut être représenté par une différence de potentiel nulle entre les électrodes de source/drain et par la présence d'un potentiel de grille égal à -1,7V.

La phase de lecture est réalisée en basculant la diode à l'état passant, à l'instant t₇, de préférence pendant une courte période pour avoir une vitesse de lecture élevée. Durant la phase de lecture, le circuit de commande est configuré de manière à appliquer un potentiel plus important sur l'électrode dopée de type P que sur l'électrode dopée de type N, la diode est à l'état passant. Le circuit de commande est également configuré de manière à abaisser la barrière de potentiel faisant face à l'électrode de grille 1.

Si la cellule mémoire est dans le premier état, la diode à l'état passant n'est pas en mesure de faire basculer le transistor à l'état passant car la barrière de potentiel sous la grille est maintenue, il n'y a donc pas passage d'un courant entre les électrodes de source et de drain.

Si la cellule mémoire est dans le second état, des charges sont stockées dans le condensateur du diélectrique de grille, dans la barrière de potentiel faisant face à l'électrode de grille. La barrière de potentiel est abaissée à cause des charges stockées. Le basculement de la diode à l'état passant va décharger, de manière transitoire le condensateur du diélectrique de grille et générer le basculement du transistor à l'état passant. Il y a passage d'un courant entre les électrodes de source et de drain indiquant que la cellule mémoire et dans le second état.

Il a été observé qu'un basculement trop lent depuis l'état bloqué vers l'état passant de la diode se traduit pas une perte des charges présentes dans le condensateur sans basculement du transistor à l'état passant. Cette vitesse de basculement dépend principalement des dimensions du transistor et de la quantité de charges stockées dans le condensateur.

Comme les charges vont s'écouler à travers la diode suite à la diminution de la barrière de potentiel, le basculement de la diode depuis son état bloquant vers son état passant est configuré de manière à faire basculer le transistor à l'état passant quand des charges sont stockées dans le condensateur. De manière pratique, il suffit d'avoir un basculement rapide de la différence de potentiel appliquée aux bornes de la diode.

De manière avantageuse, la vitesse minimale de basculement de la diode depuis l'état bloquant vers l'état passant est égale à 10³V/s de préférence égale à 10⁷V/s.

Un tel dispositif permet d'obtenir une durée de lecture de l'ordre de 1 ns.

De manière préférentielle, la différence de potentiel appliquée à la diode pour devenir passante est sous la forme d'une impulsion. Cette impulsion est configurée de manière à faire basculer la diode dans un état passant tout en évitant de décharger le condensateur du diélectrique de grille lorsque la cellule mémoire est dans le second état. Cette précaution permet d'obtenir une lecture non destructive de l'information stockée. L'impulsion décharge le condensateur de manière à faire passer le transistor à l'état passant ce qui a pour effet de recharger le condensateur pour une éventuelle nouvelle étape de lecture. L'utilisation d'une impulsion permet en plus de réaliser une lecture rapide de la cellule mémoire. A un instant t₈, le potentiel de drain est modifié de manière à repasser la diode à l'état bloqué. A partir de cet instant le transistor est dans la phase de maintien de l'information.

Par ailleurs, l'utilisation d'une phase de lecture par impulsion permet d'améliorer les conditions de rétention du premier état en réalisant la décharge du condensateur qui a pu être chargé à cause des fuites présentes dans le condensateur.

Dans les dispositifs obtenus, une impulsion égale à 15 nanosecondes appliquée sur l'électrode de drain toutes les 5 millisecondes permet de conserver l'information enregistrée pendant plus de 1000 phases de lecture et elle n'engendre pas la transformation du premier état en un deuxième état.

Un tel dispositif permet d'avoir une durée de maintien de l'information de l'ordre de 1 seconde.

Dans un mode de réalisation particulier, une matrice de cellules mémoires est formée. La matrice comporte une pluralité de cellules mémoires qui sont couplées entre elles au moyen d'une ou plusieurs lignes de commande.

Une ligne de commande est une ligne qui permet d'imposer le potentiel, de grille, de drain ou de source. Pour former une matrice compacte et facilement exploitable, il est avantageux d'avoir une organisation en rangées et en colonnes. Une première ligne de commande relie par exemple toutes les cellules mémoires d'une même rangée et une deuxième ligne de commande relie toutes les cellules mémoires d'une même colonne. Une organisation inverse est également possible. De cette manière, la sélection d'une cellule mémoire est réalisée en polarisant les deux lignes de commandes relatives à la cellule mémoire recherchée. Les deux lignes de commandes sont polarisées de manière à avoir la diode du transistor et la première barrière de potentiel Q dans l'état recherché afin de réaliser l'écriture d'un état haut ou bas, la lecture ou le maintien de l'information stockée.

Les électrodes de grille sont couplées à des premières lignes de commande. Les électrodes de source ou de drain sont couplées à des deuxièmes lignes de commande. Les électrodes de drain ou de source peuvent être couplées à une troisième ligne de commande organisée en ligne ou en colonne, mais il est avantageux de fixer un potentiel commun pour toutes les électrodes de source de la matrice, par exemple la masse. L'utilisation d'un potentiel commun permet de réduire le nombre de lignes à gérer dans la matrice ce qui facilite la compacité.

Comme les phases d'écriture, de lecture et de maintien de l'information nécessitent d'appliquer deux jeux de potentiels spécifiques pour l'actionnement de la diode et de la première barrière de potentiel, il faut s'assurer que l'écriture d'un état dans une cellule ne se traduise pas par une initialisation ou l'écriture de cet état pour toutes les cellules d'une même rangée ou d'une même colonne, par exemple, la phase d'écriture d'un état bas ou de remise à zéro comme indiqué plus haut.

Par exemple, la remise à zéro d'une cellule mémoire est effectuée en polarisant l'électrode de grille 1 au même potentiel que le canal et/ou au même potentiel que l'électrode de source/drain la plus proche, ici l'électrode de drain. Lors de la remise à zéro, la diode est à l'état bloquant.

Si deux cellules partagent, par exemple, les mêmes lignes de commande pour moduler le potentiel de l'électrode de drain et de l'électrode de grille, l'initialisation d'une cellule entraîne l'initialisation des cellules partageant les mêmes lignes de commande.

Afin de limiter, voire d'empêcher ce cas de figure, différents jeux de potentiels sont appliqués selon que l'information de la cellule doit être modifiée ou conservée et selon que la cellule partage une ligne de commande avec une cellule devant être modifiée ou non.

La remise à zéro de la cellule est réalisée en modifiant les polarisations appliquées sur les bornes du condensateur de manière à avoir une différence de potentiel nulle ou quasi-nulle à ses borne. De manière préférentielle, la remise à zéro de la cellule est réalisée en ayant une différence de potentiel nulle entre l'électrode de grille et l'électrode de source/drain la plus proche de l'électrode de grille (V_{grille}=V_{drain}).

Un premier mode de mise en oeuvre est obtenu en décalant la tension de source et la tension de drain de la cellule devant être modifiée par rapport aux autres cellules. Le décalage des tensions de source et de drain est réalisé de manière à avoir une tension de source et de drain sur la cellule à modifier supérieure à la tension de drain des autres cellules (à l'exception des cellules partageant la même ligne de commande de drain). Ainsi, le décalage réalisé sur l'électrode de grille pour obtenir l'initialisation du condensateur permet de conserver la barrière de potentiel pour toutes les autres cellules partageant la même ligne de commande de grille. Ce mode de réalisation est particulièrement efficace lorsque une même ligne de cellule ne partage pas les mêmes lignes de commande de drain et de grille.

Dans un second mode de réalisation plus général, particulièrement intéressant si le potentiel de source est commun à toutes les cellules mémoires de la matrice, le potentiel appliqué sur l'électrode de drain est modifié afin de se rapprocher du potentiel permettant le basculement de la diode à l'état passant. La diode est à l'état bloqué, ce qui peut se traduire par la relation suivante |V_{drain}-V_{source}|=0,7V, où 0,7V représente la tension à partir de laquelle un courant important passe à travers une diode en silicium si le transistor est formé dans un substrat en silicium. Une autre valeur seuil peut être appliquée si le matériau semi-conducteur est différent du silicium.

En d'autres termes, l'écart à la différence de potentiel entre les électrodes de source et de drain nécessaire pour obtenir l'état passant de la diode est plus faible pour les cellules mémoires appartenant à la même rangée ou à la même colonne que pour la cellule à modifier.

Le potentiel appliqué sur l'électrode de grille est également modifié afin d'être égal ou sensiblement égal à celui de l'électrode de source/drain la plus proche, ici l'électrode de drain. L'initialisation de la cellule choisie a lieu en appliquant une différence de potentiel nulle entre ses bornes et seule cette cellule est dans cette configuration ce qui empêche l'initialisation des autres cellules partageant les mêmes première et deuxième lignes de commande.

Lors de l'initialisation d'une cellule prédéfinie, le potentiel de la première ligne de commande et le potentiel de la deuxième ligne de commande sont configurés de manière à ce que les potentiels appliqués sur les deux électrodes du condensateur soient identiques ou sensiblement identiques. La différence de potentiel entre les deux lignes de commandes est nulle ou sensiblement nulle pour les deux lignes définissant la cellule mémoire à initialiser. Les potentiels appliqués sur les deux lignes de commande sont configurés de manière à réduire l'amplitude de la première barrière de potentiels par rapport aux autres cellules partageant la même deuxième ligne de commande. Les potentiels appliqués sur les deux lignes de commande sont configurés de manière à rapprocher la diode de l'état passant par rapport aux autres cellules partageant la même première ligne de commande. De manière avantageuse, le potentiel de l'électrode de source est la masse et le potentiel de l'électrode de drain est inférieur ou égal à 0,7V tout en s'assurant que la diode reste à l'état bloqué. La variation de potentiel appliquée sur l'électrode de drain est identique ou sensiblement identique à la variation appliquée sur l'électrode de grille en valeur absolue de manière à ce que les cellules partageant la même ligne de commande de drain et les cellules partageant la même ligne de commande de grille perdent sensiblement la même quantité de charges électriques dans le condensateur.

En d'autres termes, le circuit de commande est configuré pour initialiser une cellule mémoire prédéfinie en appliquant avantageusement une différence de potentiel nulle entre les première et deuxième lignes de commande associées à la cellule prédéfinie et à diminuer l'amplitude de la première barrière de potentiel par rapport aux autres cellules mémoires couplées à la même première ligne de commande.

Il en va de même lors de l'écriture d'un deuxième état dans une cellule prédéfinie pour éviter l'écriture d'un premier état dans les cellules partageant la même ligne de commande de grille. La variation appliquée sur l'électrode de grille en valeur absolue est avantageusement égale à la moitié de la différence de potentiel appliquée entre les électrodes de source et de drain pour passer la diode à l'état passant et limiter la décharge des condensateurs des autres cellules mémoires.

Un tel dispositif permet de travailler dans une gamme de tension inférieure à ce qui est utilisé pour les dispositifs de l'art antérieur tout en pouvant atteindre des performances identiques voire meilleures, notamment en ce qui concerne la vitesse de programmation, de lecture ou la durée de rétention de l'information dans une configuration simple ou matricielle.

## Revendications

1. Cellule mémoire comportant :
- un transistor à effet de champ comportant :
○ une première électrode de source/drain (2) formée dans un film en matériau semi-conducteur (4) par une première zone dopée de type N,
○ une deuxième électrode de source/drain (3) formée dans le film en matériau semi-conducteur (4) par une deuxième zone dopée de type P,
○ une zone inter-électrode formée dans le film en matériau semi-conducteur (4) et séparant les deux électrodes de source/drain (2, 3),
○ une électrode de grille (1, 14) recouvrant au moins partiellement la zone inter-électrode,
○ une contre-électrode (14, 1) séparée de l'électrode de grille (1, 14) par le film en matériau semi-conducteur (4),
- un premier dispositif de génération d'une première barrière de potentiel (Q) dans le film semi-conducteur (4), la première barrière de potentiel (Q) s'opposant au passage de porteurs de charge émis par la première électrode de source/drain (2),
- un deuxième dispositif de génération d'une deuxième barrière de potentiel (R) dans le film semi-conducteur (4), la deuxième barrière de potentiel (R) s'opposant au passage de porteurs de charge émis par la deuxième électrode de source/drain (3), la deuxième barrière de potentiel (R) étant décalée de la première barrière de potentiel (Q) selon un axe (X) reliant les deux électrodes de source/drain (2, 3), l'un des dispositifs de génération de barrière de potentiel (Q, R) étant configuré pour générer une barrière de potentiel à amplitude modulable et étant relié électriquement à l'électrode de grille (1, 14), l'autre des dispositifs de génération de barrière de potentiel (Q, R) étant relié électriquement à la contre-électrode (14, 1),
- un circuit d'application d'une première différence de potentiel entre la première électrode de source/drain (2) et la deuxième électrode de source/drain (3) configuré pour polariser l'électrode dopée de type P à un potentiel supérieur à celui de l'électrode dopée de type N,
- un circuit de commande configuré pour :
○ basculer le transistor à l'état passant puis à l'état bloquant pour écrire un état dans la cellule mémoire en chargeant le condensateur formé par l'électrode de grille (1) et le film semi-conducteur (4),
○ décharger le condensateur pour réinitialiser la cellule mémoire et,
○ appliquer un potentiel plus important sur l'électrode (2, 3) dopée de type P que sur l'électrode (3, 2) dopée de type N durant la phase de lecture de l'information stockée dans la cellule mémoire de manière à rendre le transistor passant lorsque le condensateur est chargé.

2. Cellule mémoire selon la revendication 1 dans laquelle l'autre des dispositifs de génération de barrière de potentiel (Q, R) comporte un film isolant de recouvrement (10) configuré de manière à présenter des charges électriques à l'interface entre le film isolant de recouvrement (10) et le film semi-conducteur (4) ou dans le film isolant de recouvrement (10).

3. Cellule mémoire selon l'une des revendications 1 et 2, dans laquelle le film semi-conducteur (4) est séparé d'un substrat de support (6) par un film électriquement isolant (7), l'électrode de grille (1) étant séparée du substrat de support (6) par le film électriquement isolant (7).

4. Cellule mémoire selon la revendication 3, dans laquelle l'autre des dispositifs de génération de puits de potentiel (Q, R) comporte une zone dopée additionnelle formée dans le film en matériau semi-conducteur (4), la zone dopée additionnelle formant une jonction PN ou NP à l'interface avec une des deux électrodes de source/drain (2, 3).

5. Cellule mémoire selon la revendication 4, dans laquelle le film semi-conducteur (4) comporte deux diodes de type PN ou NP montées en séries dans le même sens entre la première et la deuxième électrodes de source/drain (2, 3).

6. Cellule mémoire selon l'une quelconque des revendications 1 à 5, dans laquelle la contre-électrode (14, 1) recouvre toute la surface inter-électrode.

7. Cellule mémoire selon l'une quelconque des revendications 1 à 6, comportant un circuit de polarisation de l'électrode de grille (1, 14) configuré pour appliquer une différence de potentiel entre la première électrode de source/drain (2) et l'électrode de grille (1, 14) qui est de même signe que la différence de potentiel entre la première électrode de source/drain (2) et la deuxième électrode de source/drain (3).

8. Cellule mémoire selon l'une quelconque des revendications 1 à 7, dans laquelle une électrode de grille additionnelle (11, 12) dissociée électriquement de l'électrode de grille (1), l'autre des dispositifs de génération de barrière de potentiel (Q, R) est configuré pour générer une barrière de potentiel et est relié électriquement à l'électrode de grille additionnelle (11, 12).

9. Matrice mémoire comportant :
- une pluralité de cellules mémoires selon l'une quelconque des revendications 1 à 8, les cellules mémoires étant organisées selon des première et deuxième directions non parallèles,
- une première ligne commande couplant les électrodes de grille des cellules mémoires organisées selon une première direction,
- une deuxième ligne de commande couplant l'électrode de source/drain adjacente à l'électrode de grille des cellules mémoires organisées selon la deuxième direction,
le circuit de commande est configuré pour initialiser une cellule mémoire prédéfinie en appliquant une différence de potentiel nulle entre les première et deuxième lignes de commande associées à la cellule prédéfinie et à diminuer l'amplitude de la première barrière de potentiel par rapport aux autres cellules mémoires couplées à la même première ligne de commande.
